(19) Europäisches Patentamt
European Patent Office
Office européen des brevets

(11) **EP 2 013 678 B1**

(12) **EUROPEAN PATENT SPECIFICATION**

(45) Date of publication and mention
of the grant of the patent:
**26.03.2014 Bulletin 2014/13**

(51) Int Cl.:
***G05F 3/20*** *(2006.01)*

(21) Application number: **07760221.7**

(22) Date of filing: **05.04.2007**

(86) International application number:
**PCT/US2007/066102**

(87) International publication number:
**WO 2007/118171 (18.10.2007 Gazette 2007/42)**

(54) **BIAS GENERATOR**

VORSPANNUNGSGENERATOR

GÉNÉRATEUR DE POLARISATION

(84) Designated Contracting States:
**AT BE BG CH CY CZ DE DK EE ES FI FR GB GR
HU IE IS IT LI LT LU LV MC MT NL PL PT RO SE
SI SK TR**

(30) Priority: **07.04.2006 US 400592**

(43) Date of publication of application:
**14.01.2009 Bulletin 2009/03**

(73) Proprietor: **Qualcomm Incorporated
San Diego, CA 92121-1714 (US)**

(72) Inventor: **CICALINI, Alberto
San Diego, California 92122 (US)**

(74) Representative: **Heselberger, Johannes et al
Bardehle Pagenberg Partnerschaft mbB
Patentanwälte, Rechtsanwälte
Prinzregentenplatz 7
81675 München (DE)**

(56) References cited:
**EP-A1- 1 388 776    WO-A-97/50026
US-A- 5 359 296**

**Description**

**Field**

The present invention relates in general to bias generator circuits, and more specifically to bias generators with minimized susceptibility to environmental and manufacturing changes.

**Background**

A bias generator provides a bias voltage to a device such as transistor to allow the device to operate in a preferred region of the device operational characteristics. In many applications, the selection of the relative sizes of the transistors used in the bias generator and the load device is critical to maintain the operational characteristics within an acceptable region over variances due to temperature and manufacturing. For example, bias generators are often used to set a voltage at an input of a low noise amplifier (LNA) transistor where small changes in operational characteristics result in increased noise and non-linear input to output relationships. Since the devices used to implement bias generators are susceptible to temperature and manufacturing process variations, conventional biasing schemes, as described, for example, in EP 1 388 776 A1, attempt to minimize the effects of temperature and process fluctuations. For example, WO 97/50026 describes a biasing generator providing a bias current having a positive temperature coefficient to minimize the influence of temperature changes on the operation of the biasing generator. In an attempt to maximize the performance of the biased device, conventional bias generates consume significant amounts of current relative to the current used by the biased device. Performance of bias generators typically suffers when the devices in the bias generator are mismatched from the biased device. A mismatch between devices causes time-independent random variations in physical characteristics of identically designed devices. Typical characteristics that may be different between mismatched devices include device dimensions, threshold voltage, and mobility. Performance of a bias generator is typically improved by selecting a biasing device similar to the biased device. Unfortunately, conventional biasing schemes typically require a significant tradeoff between current draw and relative device size between the biased device and the devices in the bias generator.

Therefore, there is a need for a bias generator with minimized current consumption and maximized performance.

**SUMMARY**

This need is fulfilled by the subject matter of the independent claim. In accordance with the exemplary embodiment, a bias generator comprises a first biasing means and a second biasing means having a control port connected to a control port of the first biasing means and to an input port of the second biasing means, where a second current through the second biasing means is greater than a first current through the first biasing means. The current through the bias generator is minimized by providing the different currents through the biasing means having a similar size.

**BRIEF DESCRIPTION OF THE DRAWINGS**

FIG. 1 is a block diagram of a bias generator connected to a biased device in accordance with an exemplary embodiment of the invention.
FIG. 2 is a schematic representation of the exemplary bias generator where the current sources and the transistors are field effect transistors (FETs).
FIG. 3 is a schematic diagram of a conventional bias generator.

**DETAILED DESCRIPTION**

In the exemplary embodiment, current through a bias generator is minimized by providing different currents through transistors having a similar size. As compared to conventional bias generators where equal current are forced through devices of different sizes, the overall current consumption of the exemplary bias generator is less. The word "exemplary" is used herein to mean "serving as an example, instance, or illustration." Any embodiment described herein as "exemplary" is not necessarily to be construed as preferred or advantageous over other embodiments.

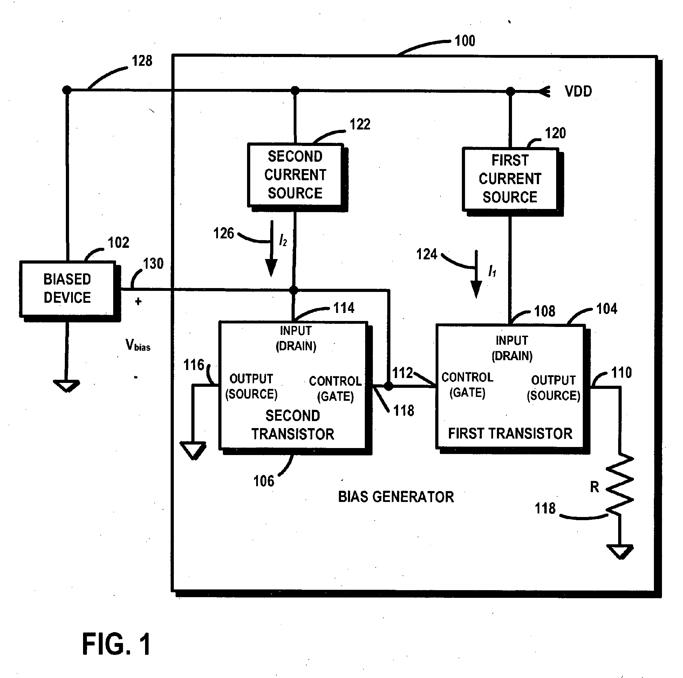

FIG. 1 is a block diagram of a bias generator 100 connected to a biased device 102 in accordance with the exemplary embodiment of the invention. The various functional blocks of the bias generator 100 may be implemented using any combination of discrete devices, integrated circuits and/or logic circuits. Two or more of the functional blocks may be integrated in a single device and the functions described as performed in any single device may be implemented over several devices in some circumstances.

The bias generator 100 includes at least two transistors 104, 106 that provide a bias voltage ($V_{bias}$) 130 to the biased device 102. Each of the transistors 104, 106 has an input port 108, 114, an output port 110, 116, and a control port 112, 118 where the voltage at the control port 112, 118 determines the current flow through the transistor 104, 106 from the input port 108, 114 to the output port 110, 116. Where the transistor is a field effect transistor (FET), the input port 108, 114, output port 110, 116 and control port 112, 118 are the drain, source and gate of the FET, respectively. Where the transistor is a bipolar junction transistor (BJT), the input port 108, 114, output port 110, 116 and control port 112, 118 are the collector, emitter and base of the BJT, respectively. Those skilled in the art will readily apply the teachings herein to known techniques in order to utilize any of numerous three terminal devices to implement the bias generator.

In the exemplary embodiment, the first control port 112 of the first transistor 104 is connected to the second control port 118 of the second transistor 106. The common node formed at the two control ports 112, 118 is connectable to the biased device 102 to provide the bias voltage 120 ($V_{bias}$). The first output port 110 of the first transistor 104 is connected to ground through a reference load (R) 118. A first current source 120 supplies a first current ($I_1$) 124 to the first transistor 104 from a power supply at a voltage (VDD) 128. The first current ($I_1$) 124 flows from the input port through the transistor to the output port and through the reference load 118. A second current source supplies a second current ($I_2$) to the second transistor 106. Although other devices may be used in some circumstances for implementing the current sources 120, 122, the first current source 120 and the second current source 122 are field effect transistors (FETs) in the exemplary embodiment.

In order to minimize the total current consumption while minimizing the variation of the bias voltage over temperature and manufacturing variations, the second current 122 source provides a second current ($I_2$) that is greater than the first current ($I_1$) and the difference in size between the first transistor 104 and the second transistor 106 is minimized. In the exemplary embodiment, the first transistor 104 and the second transistor 106 are selected to have the same size. As discussed below, the total current through the bias generator 100 is minimized while the performance is maximized.

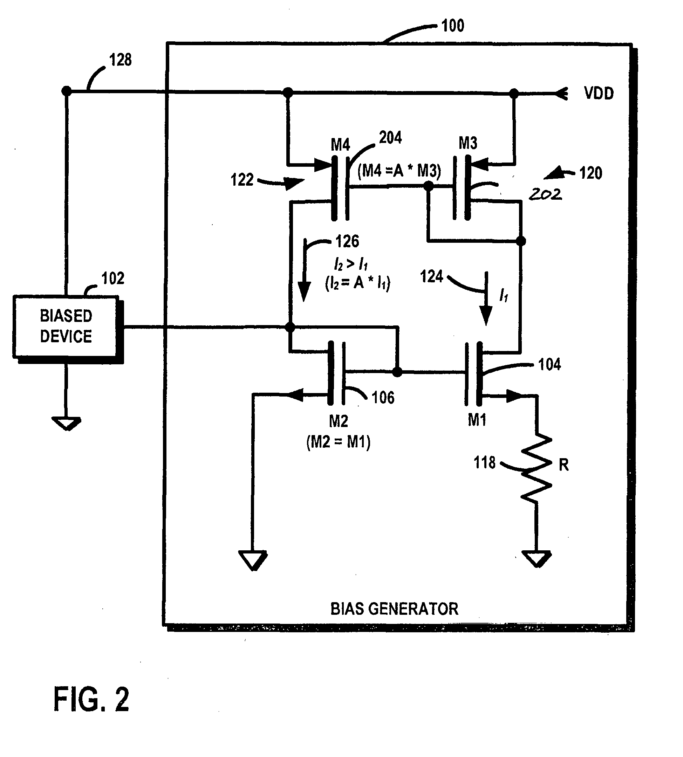

FIG. 2 is a schematic representation of the exemplary bias generator 100 where the current sources 120, 122 and the transistors 104, 106 are field effect transistors (FETs). As explained above, the bias generator 100 may be implemented using BJTs or other three terminals devices.

A field effect transistor (FET) is typically fabricated using any of numerous doping techniques to create a channel in a substrate. The channel may be formed with one or more elements often referred to as "fingers". The operational characteristics of the FET depend on the aspect ratio of the fingers and the number of fingers where the aspect ratio is the ratio of the width ($W_f$) to the length ($L_f$) of the finger. The size (M) of the FET is the aspect ratio of each finger ($W_f/L_f$) time the number of fingers ($N_f$). Therefore, the size of the first transistor and the second transistor can be expressed as follows:

$$M_1 = M_2 = N_f * \frac{W_f}{L_f} \tag{1}$$

where $M_1$ is the size of the first transistor, $M_2$ is the size of the second transistor, $W_f$ is the width of each finger, $L_f$ is the length of each finger, and $N_f$ is the total number of fingers.

In the exemplary embodiment, the first current source 120 includes a third FET 202 where the gate is connected to the source and the second current source 122 includes a fourth FET 204. The first current ($I_1$) 124 and the second current ($I_2$) 126 are determined, at least in part, by the sizes ($M_3$, $M_4$) of the third FET 202 and the fourth FET 204. In the exemplary embodiment, the size of the fourth FET ($M_4$) is selected to be approximately A times the size ($M_3$) of the third FET 202 in order that the second current ($I_2$) 126 be about A times the first current ($I_1$) 124. Accordingly, for the exemplary embodiment, the following relationships apply.

$$M_4 = A * M_3 \tag{2}$$

$$I_2 = A * I_1 \tag{3}$$

$$I_2 = \frac{2}{R^2 * \mu_n * C_{ox} * N_f * \left(\frac{W_f}{L_f}\right)} * (\sqrt{A} - 1)^2 \qquad (4)$$

where R is the resistance of the reference load 118, $\mu_n$ is the mobility of the FETs, $C_{ox}$ is the capacitance per area of the FETs, and $N_f$ is the number of fingers of the second transistor 106. Accordingly, the current is proportional to A, the ratio of the $M_4$ to M3.

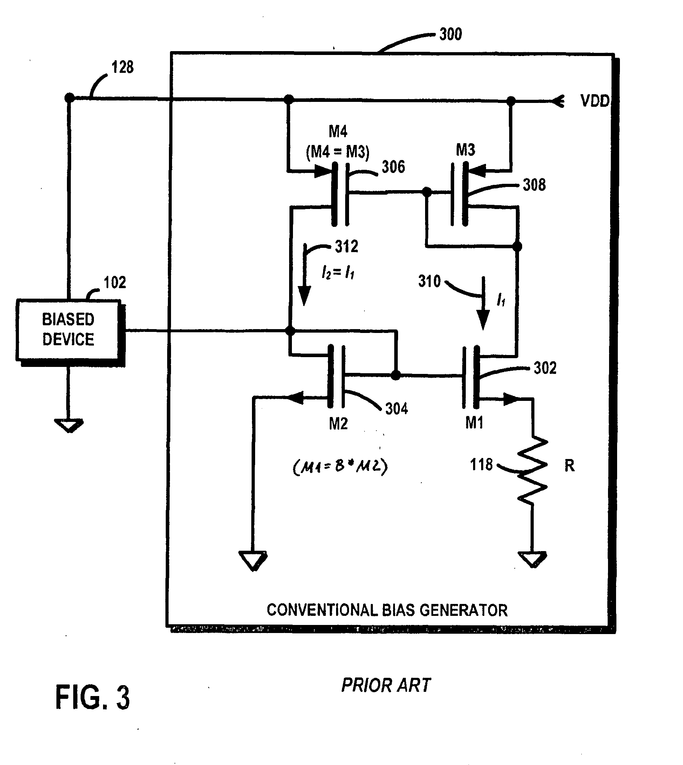

FIG. 3 is a schematic diagram of a conventional bias generator 300. The conventional bias generator 300 includes four FETs 302, 304, 306, 308, where the gates of the first FET 302 and the second FET 304 are connected to each other and to the biased device 102. In order to maintain a constant bias over temperature and manufacturing variations, conventional bias generators 300 utilize transistors that have similar channel aspect ratios but that have significant different sizes. The third transistor 308 and the fourth transistor 306 are selected such that the size (M3) of the third transistor 308 is equal to the size (M4) of the fourth transistor 306 to force the same current ($I_1 = I_2$) through the transistor pair 302, 304. In order to maintain a constant bias, the first transistor 302 and the second transistor 304 are selected such that the size of the first transistor is several times larger than the size of the second transistor. In addition, maintaining optimum performance requires the second transistor to be matched to the biased device 102. The second FET 304 is smaller than the first FET 302 by a factor of B ($M_1 = B * M_2$). The third FET and the fourth FET have the same size (M4 = M3) and the first current ($I_1$) 310 through the first FET 302 is equal to the second current ($I_2$) 312 through the second FET 304. Typically, the transistors are selected such that the following relationships apply.

$$M_4 = M_3 \qquad (5)$$

$$M_2 = N_f * \frac{W_f}{L_f} \qquad (6)$$

$$M_1 = B * N_f * \frac{W_f}{L_f} \qquad (7)$$

$$I = \frac{2}{R^2 * \mu_n * C_{ox} * N_f * \left(\frac{W_f}{L_f}\right)} * \left(1 - \frac{1}{\sqrt{B}}\right)^2 \qquad (8)$$

Comparing the conventional bias generator 300 to the exemplary bias generator 100, it can be seen that the total current in the exemplary bias generator 100 is less than the total current in the conventional bias generator 300 for biasing the same biased device. The current savings is easily observed when applying values in the following example.

For the example, the biased device 102 has a channel width ($W_{biased}$) equal to 500$\mu$m resulting in a bias current ($I_{biased}$) through the biased device 102 equal to 10mA. For the comparison, scaling factors A and B are both equal to 4. In both the conventional bias generator 300 and the exemplary bias generator 100, the sizes ($M2_{Conv}$) ($M2_{Ex}$) are ten times smaller than the biased device 102 and, therefore, the channel widths ($WM2_{Conv}$) ($WM2_{Ex}$) of the second transistors 304, 106 are selected to be ten times smaller than the biased device width. Accordingly, $WM2_{Conv} = WM2_{Ex} = 500\mu$m /10 = 50$\mu$m. The current ($I_2$) through the second transistors 106, 304 is equal to 10mA/10 = 1mA. Since the current through the first transistor 302 in the conventional bias generator 300 is the same as the current through the second transistor 304, the current through the first transistor 302 is equal to 1mA and the total current through the bias generator 300 is equal to 2mA. The size ($M1_{Conv}$) of the first transistor 302, however, is four times larger than the size ($M2_{Conv}$) of the second transistor 304 resulting in a channel width ($W_{M2Conv}$) equal to 12.5$\mu$m. In the exemplary bias generator 100 discussed with reference to FIG. 2 above, however, the size (M1) of the first transistor 104 is the same as the size (M2) of the second transistor 106. Accordingly, the channel width ($W_{M1EX}$) of the first transistor 104 is equal to 50$\mu$m. The current ($I_{1EX}$) through the first transistor 104 in the exemplary embodiment is at least partially determined by the third transistor 120. Since M4 = A* M3, the current ($I_{1EX}$) through the first transistor 104 is equal to the current ($I_2$) through the second transistor 106 divided by the scaling factor (A) which is equal to 4 in the current example. Accordingly, the current ($I_{1EX}$) through the first transistor 104 is equal to 1mA/4 = 250$\mu$A. Therefore, the total current through the exemplary bias generator 100 for the example is equal to 1mA + 0.25mA = 1.25mA which is about 12.5% of the current through the biased device 102. In comparison, the total current through the conventional bias generator 300 is 20% of the current through the biased device 102. In addition to having reduced current through the exemplary biased generator 100, the first transistor 104 is four times larger than the corresponding first transistor 302 of the conventional bias generator 300. As a result, the match between the biased device 102 and the biasing devices (104, 106) is improved resulting in better performance. In addition, conventional biasing techniques require matching between at least three transistors including the biased device 102, having size X, the second transistor 304, having size X/10 and the first transistor 302, having size X/2.5. In the exemplary bias generator 100, however, only one transistor size must be matched to the biased device 102, having size X, since both the first transistor 104 and the second transistor 106 has the same size, X/10.

## Claims

1. A bias generator (100) comprising:

   a first transistor (104) having a first input port (108), first output port (110) and a first control port (112), where a voltage at the first control port (112) determines a first current through the first transistor (104) from the first input port (108) to the first output port (110),
   a reference load (118) connected from the first output port (110) to a common potential;
   a second transistor (106) having a second input port (114) and a second output port (116), and having a second control port (118) connected to the first control port (112) and the second input port (114), where the voltage at the first control port (112) determines a second current (126) through the second transistor (106) from the second input port (114) to the second output port (116) control ports (112, 118) connectable to a biased device (102);
   a first current source (120) providing the first current (124), wherein the first current source (120) comprises a third transistor (204) having a third input port, a third output port and a third control port connected to the third output port; and
   a second current source (122) providing the second current (126) greater than the first current (124), wherein the second current source (122) comprises a fourth transistor (204) having a fourth input port, a fourth output port and a fourth control port connected to the third control port, and
   wherein a fourth transistor size is greater than a third transistor size and
   the first transistor (104) and the second transistor (106) have a similar size.

2. The bias generator (100) in accordance with claim 1, wherein a first transistor size is the same as a second transistor size.

3. The bias generator (100) in accordance with claim 1, wherein the fourth transistor size is at least twice the third transistor size.

4. The bias generator (100) in accordance with claim 3, wherein the fourth transistor size is at least four times the third transistor size.

5. The bias generator (100) in accordance with any of claims 1 to 4, wherein the second current (126) is at least twice the first current (124).

6. The bias generator (100) in accordance with claim 5, wherein the second current (126) is at least four times greater than the first current (124).

7. The bias generator (100) according to any of claims 1 to 6, wherein the first transistor is a first field effect transistor, FET, having a first drain, first source, and a first gate, where a voltage at the first gate determines a first current through the first FET from the first drain to the first source,
   the reference load is connected from the first source to a common potential;
   the second transistor is a second FET having a second drain and a second source, and having a second gate connected to the first gate and the second drain, where the voltage at the first gate determines a second current through the second FET from the second drain to the second source, the gates connectable to a biased device having a device channel aspect ratio the same as a second FET channel aspect ratio of the second FET; the first current source is a third FET providing the first current; and the second current source is a fourth FET providing the second current greater than the first current.

**8.** The bias generator (100) in accordance with claim 7, wherein the second current is at least twice the first current.

**9.** The bias generator (100) in accordance with claim 8, wherein the second current is at least four times the first current.

**10.** The bias generator (100) in accordance with claim 7, wherein a fourth FET size is at least twice a third FET size.

**11.** The bias generator (100) in accordance with claim 10, wherein a fourth FET size is at least four times a third FET size.

**Patentansprüche**

**1.** Ein Vorspannungsgenerator (100) aufweisend:

einen ersten Transistor (104) mit einem ersten Eingangsanschluss (108), einem ersten Ausgangsanschluss (110) und einem ersten Steueranschluss (112), wobei eine Spannung an dem ersten Steueranschluss (112) einen ersten Strom durch den ersten Transistor (104) von dem ersten Eingangsanschluss (108) an den ersten Ausgangsanschluss (110) bestimmt, eine Referenzlast (118), die von dem ersten Ausgangsanschluss (110) mit einem gemeinsamen Potential verbunden ist; einen zweiten Transistor (106) mit einem zweiten Eingangsanschluss (114) und mit einem zweiten Ausgangsanschluss (116), und mit einem zweiten Steueranschluss (118), der mit dem ersten Steueranschluss (112) und dem zweiten Eingangsanschluss (114) verbunden ist, wobei die Spannung an dem ersten Steueranschluss (112) einen zweiten Strom (126) bestimmt durch den zweiten Transistor (106) von dem zweiten Eingangsanschluss (114) an die zweiten Ausgangsanschluss- (116) Steueranschlüsse (112, 118), verbindbar mit einem vorspannungsbeaufschlagten Gerät (102); eine erste Stromquelle (120), die den ersten Strom (124) bereitstellt, wobei die erste Stromquelle (120) einen dritten Transistor (204) aufweist mit einem dritten Eingangsanschluss, einem dritten Ausgangsanschlus und einem dritten Steueranschluss, der mit dem dritten Ausgangsanschluss verbunden ist; und eine zweite Stromquelle (122), die den zweiten Strom (126) höher als den ersten Strom (124) bereitstellt, wobei die zweite Stromquelle (122) einen vierten Transistor (204) aufweist mit einem vierten Eingangsanschluss, einem vierten Ausgangsanschluss und einem vierten Steueranschluss, der mit dem dritten Steueranschluss verbunden ist, und wobei eine vierte Transistorgröße größer als eine dritte Transistorgröße ist und der erste Transistor (104) und der zweite Transistor (106) eine ähnliche Größe haben.

**2.** Der Vorspannungsgenerator (100) nach Anspruch 1, wobei eine erste Transistorgröße gleich einer zweiten Transistorgröße ist.

**3.** Der Vorspannungsgenerator (100) nach Anspruch 1, wobei die vierte Transistorgröße zumindest zweimal größer als die dritte Transistorgröße ist.

**4.** Der Vorspannungsgenerator (100) nach Anspruch 3, wobei die vierte Transistorgröße zumindest viermal größer als die dritte Transistorgröße ist.

**5.** Der Vorspannungsgenerator (100) nach jedem der Ansprüche 1 bis 4, wobei der zweite Strom (126) mindestens zweimal höher als der erste Strom (124) ist.

**6.** Der Vorspannungsgenerator (100) nach Anspruch 5, wobei der zweite Strom (126) mindestens viermal höher als der erste Strom (124) ist.

**7.** Der Vorspannungsgenerator (100) nach jedem der Ansprüche 1 bis 6, wobei der erste Transistor ein Feldeffekttransistor, FET, ist mit einem ersten Drain, einer ersten Source und einem ersten Gate, wobei eine Spannung an dem ersten Gate einen ersten Strom durch den ersten FET von dem ersten Drain zu der ersten Source bestimmt, die Referenzlast ist von dem ersten Ausgangsanschluss mit einem gemeinsamen Potential verbunden;

der zweite Transistor ist ein zweiter FET mit einem zweiten Drain und einer zweiten Source, und mit einem zweiten Gate, das mit dem ersten Gate und dem zweiten Drain verbunden ist, wobei die Spannung an dem ersten Gate einen zweiten Strom bestimmt durch den zweiten FET von dem zweiten Drain an die zweite Source, die Gates sind verbindbar mit einem vorspannungsbeaufschlagten Gerät mit einem Gerät-Kanal-Seitenverhältnis, das dasselbe ist wie ein zweites FET Kanal-Seitenverhältnis von dem zweiten FET;

die erste Stromquelle ist ein dritter FET, der den ersten Strom bereitstellt; und

die zweite Stromquelle ist ein vierter FET, der den zweiten Strom höher als den ersten Strom bereitstellt.

8. Der Vorspannungsgenerator (100) nach Anspruch 7, wobei der zweite Strom mindestens zweimal höher als der erste Strom ist.

9. Der Vorspannungsgenerator (100) nach Anspruch 8, wobei der zweite Strom mindestens viermal höher als der erste Strom ist.

10. Der Vorspannungsgenerator (100) nach Anspruch 7, wobei eine vierte FET-Größe zumindest zweimal größer als eine dritte FET-Größe ist.

11. Der Vorspannungsgenerator (100) nach Anspruch 10, wobei eine vierte FET-Größe zumindest viermal größer als eine dritte FET-Größe ist.

**Revendications**

1. Un générateur de polarisation (100) comprenant :

un premier transistor (104) avec une première borne d'entrée (108), une première borne de sortie (110) et une première borne de contrôle (112), où une tension sur la première borne de contrôle (112) détermine un premier courant traversant le premier transistor (104) de la première borne d'entrée (108) vers la première borne de sortie (110) ;

une charge de référence (118) reliant la première borne de sortie (110) à un potentiel commun ;

un second transistor (106) avec une seconde borne d'entrée (114) et une seconde borne de sortie (116), et avec une seconde borne de contrôle (118) reliée à la première borne de contrôle (112) et à la seconde borne d'entrée (114), où la tension sur la première borne de contrôle (112) détermine un second courant (126) traversant le second transistor (106) de la seconde borne d'entrée (114) vers la seconde borne de sortie (116), les bornes de contrôle (112, 118) pouvant être reliées à un dispositif polarisé (102) ;

une première source de courant (120) produisant le premier courant (124), la première source de courant (120) comprenant un troisième transistor (204) avec une troisième borne d'entrée, une troisième borne de sortie et un troisième port de contrôle relié à la troisième borne de sortie ; et

une seconde source de courant (122) produisant le second courant (126) supérieur au premier courant (124), la seconde source de courant (122) comprenant un quatrième transistor (204) avec une quatrième borne d'entrée, une quatrième borne de sortie et une quatrième borne de contrôle reliée à la troisième borne de contrôle, et

dans lequel une taille du quatrième transistor est supérieure à une taille du troisième transistor et

le premier transistor (104) et le second transistor (106) sont de taille semblable.

2. Le générateur de polarisation (100) de la revendication 1, dans lequel une taille du premier transistor est la même qu'une taille du second transistor.

3. Le générateur de polarisation (100) de la revendication 1, dans lequel la taille du quatrième transistor est au moins double de la taille du troisième transistor.

4. Le générateur de polarisation (100) de la revendication 3, dans lequel la taille du quatrième transistor est au moins quatre fois la taille du troisième transistor.

5. Le générateur de polarisation (100) de l'une des revendications 1 à 4, dans lequel le second courant (126) est au moins double du premier courant (124).

**6.** Le générateur de polarisation (100) de la revendication 5, dans lequel le second courant (126) est au moins quatre fois supérieur au premier courant (124).

**7.** Le générateur de polarisation (100) de l'une des revendications 1 à 6, dans lequel le premier transistor est un premier transistor à effet de champ, FET, avec un premier drain, une première source et une première grille, où une tension sur la première grille détermine un premier courant traversant le premier FET du premier drain vers la première source ;

la charge de référence relie la première source à un potentiel commun ;

le second transistor est un second FET avec un second drain et une seconde source, et avec une seconde grille reliée à la première grille et au second drain, où la tension sur la première grille détermine un second courant traversant le second FET du second drain vers la seconde source, les grilles pouvant être reliées à un dispositif polarisé avec un ratio d'aspect de canal du dispositif qui est le même qu'un second ratio d'aspect de canal de FET du second FET ;

la première source de courant est un troisième FET délivrant le premier courant ; et

la seconde source de courant est un quatrième FET délivrant le second courant supérieur au premier courant.

**8.** Le générateur de polarisation (100) de la revendication 7, dans lequel le second courant est au moins double du premier courant.

**9.** Le générateur de polarisation de la revendication 8, dans lequel le second courant est au moins quatre fois le premier courant.

**10.** Le générateur de polarisation (100) de la revendication 7, dans lequel une dimension du quatrième FET est au moins double d'une dimension du troisième FET.

**11.** Le générateur de polarisation (100) de la revendication 10, dans lequel une dimension du quatrième FET est au moins quatre fois une dimension du troisième FET.

**FIG. 1**

FIG. 2

FIG. 3

*PRIOR ART*

**EP 2 013 678 B1**

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description

- EP 1388776 A1
- WO 9750026 A